(19) Europäisches Patentamt
European Patent Office
Office européen des brevets

(11) **EP 4 598 301 A1**

(12) **EUROPEAN PATENT APPLICATION**

(43) Date of publication:
06.08.2025 Bulletin 2025/32

(21) Application number: 25150408.0

(22) Date of filing: 07.01.2025

(51) International Patent Classification (IPC):
*H10D 30/69* (2025.01)   *H10D 64/01* (2025.01)

(52) Cooperative Patent Classification (CPC):
**H10D 30/693; H10D 64/037;** H10B 43/27;
H10B 43/30; H10D 64/689

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 05.02.2024 KR 20240017538

(71) Applicant: Samsung Electronics Co., Ltd.
Suwon-si, Gyeonggi-do 16677 (KR)

(72) Inventors:
• KIM, Taehoon
 16678 Suwon-si (KR)
• KIM, Jaewon
 16678 Suwon-si (KR)
• SHIN, Hyeonjin
 16678 Suwon-si (KR)
• NGUYEN, Vanluan
 16678 Suwon-si (KR)
• CHOI, Taejin
 16678 Suwon-si (KR)

(74) Representative: Elkington and Fife LLP
Prospect House
8 Pembroke Road
Sevenoaks, Kent TN13 1XR (GB)

(54) **VERTICAL NONVOLATILE MEMORY DEVICE AND ELECTRONIC APPARATUS INCLUDING THE SAME**

(57) Provided are a vertical nonvolatile memory device and an electronic apparatus including the same. The vertical nonvolatile memory device incudes a plurality of cell strings, and each of the plurality of cell strings includes a channel layer, a charge tunneling layer arranged on the channel layer, a charge trap layer arranged on the charge tunneling layer, a charge blocking layer arranged on the charge trap layer, a gate electrode arranged on the charge blocking layer, and a boron nitride film arranged on the gate electrode, wherein the gate electrode and the boron nitride film are alternately stacked.

FIG. 1

**Description**

FIELD OF THE INVENTION

The disclosure relates to vertical nonvolatile memory devices including a boron nitride film and electronic apparatuses including the vertical nonvolatile memory device.

BACKGROUND OF THE INVENTION

Electronic devices and semiconductor devices are mostly manufactured by combining and connecting semiconductors with insulators and conductors. For example, after forming a plurality of unit devices on a semiconductor substrate, by repeatedly stacking an insulating layer and an electrode wire thereon, various integrated circuits may be manufactured.

However, in the process of manufacturing or operating the devices, the temperature of constituent layers may increase, and electric stress may occur due to a voltage/current applied. Accordingly, diffusion of materials (atoms) may occur between adjacent constituent layers, which may lead to degradation of device characteristics and decrease in reliability and durability. When a degree of integration of device increases, it may become harder to solve the issues due to the diffusion of material between constituent layers. In addition, even when there is no diffusion of material, a signal delay may occur due to mutual interference caused by an electric field between wires of a device having a high integration degree.

As a degree of integration of integrated circuit increases significantly, a distance between conductor patterns decreases gradually. Accordingly, the parasitic capacitance between the conductor patterns increases, which may lead to performance degradation of electronic apparatuses. For example, the parasitic capacitance may delay a signal transmission of semiconductor devices. To reduce such parasitic capacitance, insulator materials having a relatively low permittivity have been used as an interlayer insulating film.

SUMMARY OF THE INVENTION

Some example embodiments provide vertical nonvolatile memory devices including a boron nitride film.

Some example embodiments provide electronic apparatuses including a vertical nonvolatile memory device including a boron nitride film.

Additional aspects will be set forth in part in the description which follows and, in part, will be apparent from the description, or may be learned by practice of the presented example embodiments of the disclosure.

According to an example embodiment of the disclosure, a vertical nonvolatile memory device includes a channel layer, a charge tunneling layer on the channel layer, a charge trap layer on the charge tunneling layer, a charge blocking layer on the charge trap layer, a gate electrode on the charge blocking layer, and a boron nitride film on the gate electrode, wherein the gate electrode and the boron nitride film are alternately stacked, and the boron nitride film has a dielectric constant of 4 or less at an operating frequency of 100 kHz and has a Young's modulus of 60 Gpa or greater.

The boron nitride film may have a thickness of 16 nm or less.

A ratio of boron to nitrogen of the boron nitride film may be about 0.9 to about 1.1.

The boron nitride film may have a mass density of about 1 $g/cm^3$ to about 3 $g/cm^3$

The boron nitride film may have a breakdown field of 4 $MVcm^{-1}$ or greater.

The boron nitride film may have a roughness of about 0.3 root-mean-square (RMS) to about 0.6 RMS.

The boron nitride film may have a hydrogen content of 10 % or less.

The boron nitride film may have an amorphous structure or a nanocrystal structure.

The charge blocking layer may include a first charge blocking layer and a second charge blocking layer, and the second charge blocking layer may include a fluorite-based material, a perovskite-based material, or a wurtzite-based material.

The fluorite-based material may include $HfO_2$ or $ZrO_2$.

The fluorite-based material may further include a dopant, and the dopant includes at least one of Al, Ga, Co, Ni, Mg, In, La, Y, Nd, Sm, Er, Sr, Ba, Gd, Ge, N, or Si.

The perovskite-based material may include a material having an ABOs composition where A and B are metal elements.

The perovskite-based material may include at least one of PbZrOs, PbTiOs, BaTiOs, SrTiOs, or CaTiOs.

The wurtzite-based material may include at least one of AlN, GaN, InN, doped AlN, doped GaN, or doped InN.

The second charge blocking layer may have a thickness of about 1 nm to about 3 nm.

The vertical nonvolatile memory device may further include a diffusion preventing layer between the gate electrode and the charge blocking layer.

The diffusion preventing layer may include at least one of titanium (Ti), zirconium (Zr), vanadium (V), aluminum (Al), lanthanum (La), niobium (Nb), or tantalum (Ta) or include a nitride including at least one of titanium (Ti), zirconium (Zr), vanadium (V), aluminum (Al), lanthanum (La), niobium (Nb), or tantalum (Ta).

According to an example embodiment of the disclosure, an electronic apparatus includes a memory and a memory controller configured to control the memory to read data from the memory and/or write data on the memory, wherein the memory is a vertical nonvolatile memory device including a plurality of cell strings, and each of the plurality of cell strings includes a channel layer, a charge tunneling layer on the channel layer, a charge trap layer on the charge tunneling layer, a charge blocking layer on the charge trap layer, a gate electrode on the charge blocking layer, and a boron nitride film on the gate electrode, wherein the gate electrode and the boron nitride film are alternately stacked, and wherein the boron nitride film has a dielectric constant of 4 or less at an operating frequency of 100 kHz and a Young's modulus of 60 Gpa or greater.

BRIEF DESCRIPTION OF THE DRAWINGS

The above and other aspects, features, and advantages of certain example embodiments of the disclosure will be more apparent from the following description taken in conjunction with the accompanying drawings, in which:

FIG. 1 is a schematic view of a vertical nonvolatile memory device according to an example embodiment;
FIG. 2 is a cross-sectional view of a memory string included in the vertical nonvolatile memory device, taken along line A-A' of FIG. 1;
FIG. 3 is an enlarged view of region A of FIG. 2;
FIGS. 4A to 4C are cross-sectional view for illustrating a method of manufacturing a boron nitride film according to an example embodiment;
FIGS. 5 and 6 are each an enlarged view of region A of FIG 2 according to some example embodiments;
FIG. 7 is a circuit diagram to which a vertical nonvolatile memory device is applied according to an example embodiment;
FIG. 8 is a schematic block diagram of a display driver integrated circuit (DDI) and a display apparatus including the DDI according to an example embodiment;
FIG. 9 is a block diagram of an electronic apparatus according to an example embodiment;
FIG. 10 is a block diagram of an electronic apparatus according to an example embodiment;
FIG. 11 is a conceptual diagram schematically illustrating a device architecture applicable to an electronic apparatus according to an example embodiment; and
FIG. 12 is a conceptual diagram schematically illustrating a device architecture applicable to an electronic apparatus according to another example embodiment.

DETAILED DESCRIPTION

Reference will now be made in detail to some example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the disclosed example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

Hereinafter, vertical nonvolatile memory devices according to various example embodiments and electronic apparatuses including the same are described in detail with reference to the accompanying drawings. In the drawings, like reference numerals in the drawings denote like elements, and sizes of components in the drawings may be exaggerated for clarity and convenience of explanation. While such terms as "first," "second," etc., may be used to describe various components, such components must not be limited to the above terms. The above terms are used only to distinguish one component from another.

An expression used in the singular encompasses the expression of the plural, unless it has a clearly different meaning in the context. When a portion "includes" an element, another element may be further included, rather than excluding the existence of the other element, unless otherwise described. Sizes or thicknesses of components in the drawings may be arbitrarily exaggerated for convenience of explanation. Further, when a certain material layer is described as being arranged on a substrate or another layer, the material layer may be in contact with the other layer, or there may be a third layer between the material layer and the other layer. In embodiments, materials constituting each layer are provided merely as an example, and other materials may also be used.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

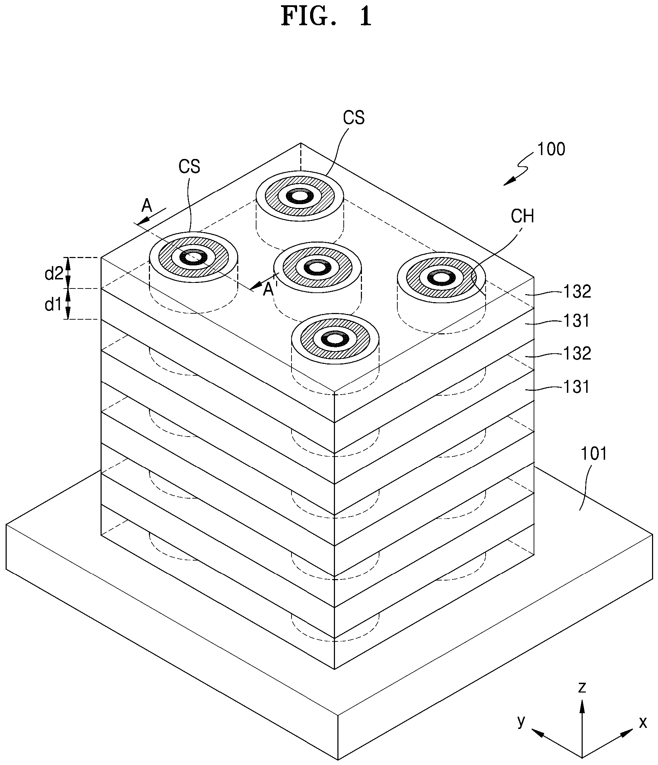

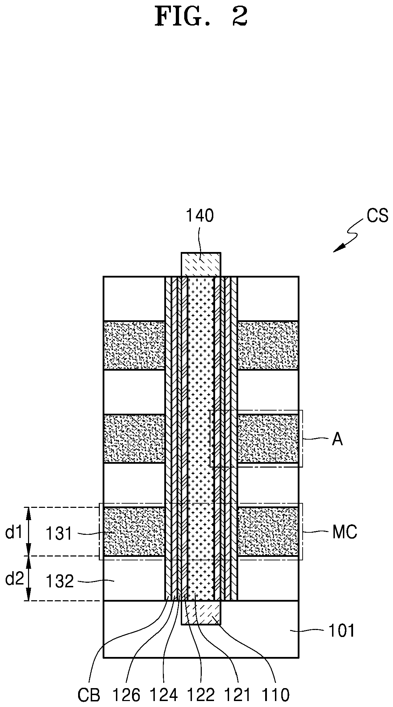

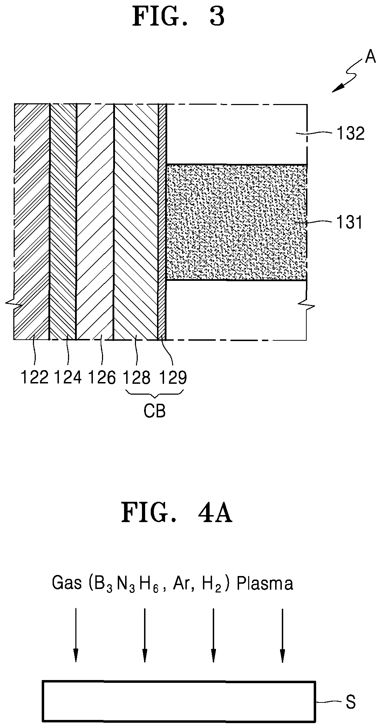

FIG. 1 is a schematic view of a vertical nonvolatile memory device according to an example embodiment, FIG. 2 is a cross-sectional view of a memory string included in the vertical nonvolatile memory device, taken along line A-A' of FIG. 1, and FIG. 3 is an enlarge view of region A of FIG. 2.

Referring to FIG. 1, a vertical nonvolatile memory device 100 may include a plurality of cell strings CS arranged on a substrate 101. Each cell string CS may extend in a direction perpendicular to the substrate 101 (e.g., z axis direction in FIG. 1). The plurality of cell strings CS may be arranged on the substrate 101 in various forms. A gate electrode 131 and a boron nitride film 132 may be alternately stacked on the substrate 101. A channel hole CH may penetrate a stack of the gate electrode 131 and the boron nitride film 132 in the direction perpendicular to the substrate 101 (e.g., z axis direction). The channel hole CH may have, for example, a circular cross-section. However, the shape of the cross-section of the channel hole CH is not limited thereto.

In the cell string CS, parts other than the gate electrode 131 and the boron nitride film 132 may have a stacked structure of a plurality of cylindrical shells in the channel hole CH. However, the structure of the cell string CS is not limited thereto, and the cell string CS may have other shapes and structures.

The substrate 101 may include a single crystal silicon substrate, a compound semiconductor substrate, or a silicon-on-insulator (SOI) substrate. However, the disclosure is not limited thereto. The substrate 101 may further include an impurity area due to doping, an electronic apparatus such as a transistor, etc., and a periphery circuit for selecting and controlling memory cells storing data, etc.

Referring to FIG. 2, the cell string CS may include a plurality of memory cells MC stacked in the direction perpendicular to the substrate 101 (z axis direction). The memory cell MC may be a base unit cell where data is written or deleted.

The cell string CS may include a pillar 121 extending in the direction perpendicular to the substrate 101, a channel layer 122 arranged on the pillar 121, a charge tunneling layer 124 arranged on the channel layer 122, a charge trap layer 126 arranged on the charge tunneling layer 124, a charge blocking layer CB arranged on the charge trap layer 126, and the gate electrode 131 arranged on the charge blocking layer CB.

The pillar 121 may include, for example, silicon oxide, air, etc. However, the disclosure is not limited thereto. Each of the channel layer 122, the charge tunneling layer 124, the charge trap layer 126 may extend in the direction perpendicular to the substrate 101 and may be shared by a plurality of memory cells MC.

The channel layer 122 may include a semiconductor material. The channel layer 122 may include, for example, Si, Ge, SiGe, or group III-V semiconductors, etc. In some example embodiments, the channel layer 122 may include, for example, an oxide semiconductor, a nitride semiconductor, an oxynitride semiconductor, a two-dimensional (2D) semiconductor material, a quantum dot, or an organic semiconductor. The oxide semiconductor may include, for example, InGaZnO, etc. The 2D semiconductor material may include transition metal dichalcogenide (TMD) or graphene, and the quantum dot may include a colloidal quantum dot, a nanocrystal structure, etc. The 2D semiconductor material may refer to a semiconductor material having a 2D crystal structure and may have a monolayer or multilayer structure. The 2D material may have excellent electrical characteristics and may be a material applicable to various devices because it maintains high mobility even in a nano-scale thickness without any significant changes in the electrical characteristics. Each layer including such 2D semiconductor material may have an atomic-level thickness. The channel layer 122 may include one to ten 2D semiconductor material layer(s).

The 2D semiconductor material may include, for example, at least one of graphene, black phosphorous, or TMD. The graphene is a material having a hexagonal honeycomb structure of carbon atoms bonded in a 2D manner and may have a higher electrical mobility and better thermal characteristics than silicon (Si). The graphene may also be chemically stable and have a wide surface area. The black phosphorous is a material in which black phosphorous atoms are bonded to each other in a 2D manner.

The TMD may be represented by, for example, $MX_2$ where M represents a transition metal, and X represents a chalcogen element. For example, M may include Mo, W, Nb, V, Ta, Ti, Zr, Hf, Tc, or Re, and X may include S, Se, or Te. Accordingly, the TMD may include, for example, $MoS_2$, $MoSe_2$, $MoTe_2$, $WS_2$, $WSe_2$, $WTe_2$, $ZrS_2$, $ZrSe_2$, $HfS_2$, $HfSe_2$, $NbSe_2$, $ReSe_2$, etc.

The 2D semiconductor material may include CuS which is a compound of Cu which is transition metal and S which is a chalcogen element. The 2D semiconductor material may be a chalcogenide material including non-transition metal. The non-transition metal may include, for example, Ga, In, Sn, Ge, Pb, etc. In this case, the 2D semiconductor material may include a compound of non-transition metal such as Ga, In, Sn, Ge, Pb, etc. and a chalcogen element such as S, Se, Te, etc. For example, the 2D semiconductor material may include $SnSe_2$, GaS, GaSe, GaTe, GeSe, $In_2Se_3$, $InSnS_2$, etc. However, the foregoing materials are just examples, and other materials may be used as the 2D semiconductor material.

The channel layer 122 may further include a dopant. The dopant may include a p-type dopant and an n-type dopant. The p-type dopant may include group III elements, such as B, Al, Ga, In, etc., and the n-type dopant may include group V elements, such as P, As, Sb, etc.

The charge tunneling layer 124 may be a layer in which charge tunneling occurs and may include, for example, a silicon oxide or a metal oxide. However, the disclosure is not limited thereto.

The gate electrodes 131 may be stacked apart from each other in the direction perpendicular to the substrate 101, and the boron nitride film 132 may be arranged between the gate electrodes 131. The boron nitride film 132 may electrically separate the gate electrodes 131 such that each of the gate electrodes 131 is driven independently in a unit of memory cell MC. Although FIG. 1 does not illustrate a source electrode and a drain electrode, FIG. 2 illustrates a source electrode 110 and a drain electrode 140. The source electrode 110 may be arranged under the channel layer 122, and the drain electrode 140 may be arranged on the channel layer 122. The drain electrode 140 may be connected to a bit line (not shown).

Although FIG. 2 illustrates that the source electrode 110 is connected to each cell string CS, the source electrode 110 may be commonly connected to the cell string CS. Although FIG. 2 illustrates that the charge blocking layer CB includes a single layer for convenience, the disclosure is not limited thereto, and the charge blocking layer CB may include multiple layers.

FIG. 3 is an enlarged view of region A of FIG. 2.

The channel layer 122 may be arranged to surround a lateral surface of the pillar 121, the charge tunneling layer 124 may be arranged to surround a lateral surface of the channel layer 122, the charge trap layer 126 may be arranged to surround a lateral surface of the charge tunneling layer 124, and the charge blocking layer CB may be arranged to surround a lateral surface of the charge trap layer 126.

In addition, the gate electrode 131 and the boron nitride film 132 may be alternately arranged along the lateral surface of the charge blocking layer CB. Each channel corresponding to the gate electrode 131 may be formed in the channel layer 122 between the source electrode 110 and the drain electrode 140. When a certain voltage is applied to the gate electrode 131 from each memory cell MC, charges flowing between the source electrode 110 and the drain electrode 140 in the channel layer 122 corresponding to the gate electrode 131 may pass through the charge tunneling layer 124 and may be trapped in the charge trap layer 126 to store information.

The gate electrode 131 may control the corresponding channel layer 122, and a word line may be electrically connected to the gate electrode 131. The gate electrode 131 may include a metal material having excellent electrical conductivity, conductive oxide, metal nitride, silicon doped with impurities, a 2D conductive material, etc. The metal material may include, for example, Au, Ti, TiN, TaN, W, Mo, WN, Pt, Nb, NbN, Ni, or any combination thereof. The conductive oxide may include, for example, indium tin oxide (ITO), indium zinc oxide (IZO), etc. However, this is just an example, the gate electrode 131 may include various other materials. The boron nitride film 132 may serve as a spacer layer for insulation between the gate electrodes 131. The boron nitride film 132 may be configured to have a dielectric constant of 4 or less at an operation frequency of 100 kHz and a Young's modulus of 60 Gpa or greater. The boron nitride film 132 may include an amorphous structure or a nanocrystal structure. The boron nitride film 132 may have, for example, a Young's modulus of about 60 Gpa to about 100 Gpa. The boron nitride film 132 may have a thickness d2 of 16 nm or less. The thickness d2 may be a thickness in a stacking direction of the gate electrode 131 and the boron nitride film 132 (e.g., a Z-direction thickness in FIG. 1). As the boron nitride film 132 has a very thin thickness while having a relatively high Young's modulus, when the boron nitride film has a lattice structure having a very thin thickness in a manufacturing process of a vertical nonvolatile memory device, the lattice structure may be supported due to a high Young's modulus. The boron nitride film 132 may have, for example, the thickness d2 of about 1 nm to about 16 nm. The boron nitride film 132 may have a thickness less than or equal to the thickness of the gate electrode 131. A ratio of the thickness d2 of the boron nitride film 132 to a thickness d1 of the gate electrode 131 (d2/d1) may be about 0.5 to about 1. The ratio of the thickness d2 of the boron nitride film 132 to the thickness d1 of the gate electrode 131 (d2/d1) may be about 0.7 to about 1. The ratio of the thickness d2 of the boron nitride film 132 to the thickness d1 of the gate electrode 131 (d2/d1) may be about 0.8 to about 1.

The charge blocking layer CB may serve as a barrier blocking the charge transfer between the charge trap layer 126 and the gate electrode 131. One surface of the charge blocking layer CB may be in contact with the charge trap layer 126, and another surface of the charge blocking layer CB may be in contact with the gate electrode 131.

The charge trap layer 126 may store inflow charges. Charges present in the channel layer 122 (e.g., electrons) may flow into the charge trap layer 126 by the tunneling effect, etc. Charges which have flowed into the charge trap layer 126 may be fixed in the charge trap layer 126.

The reliability element, which is a key requirement in a vertical nonvolatile memory device, relates to retention of data (e.g., characteristics of storing charges in the charge trap layer 126 for a long time). When a distance between the memory cells MC is reduced to increase the density of memory in a vertical nonvolatile memory device, transfer of charges trapped between the memory cells MC may occur, which may lead to degradation of charge retention characteristics.

In a direction perpendicular to the charge trap layer 126, charges may transfer from the charge trap layer 126 to the charge tunneling layer 124 by trap-assisted tunneling or thermal emission. A degree of such transfer of charges may be determined by a conduction band offset (CBO) at an interface of the charge trap layer 126 and the charge tunneling layer 124.

In a direction parallel with the charge trap layer 126, charge transfer may occur by lateral migration due to a gradient of the charge concentration. The charge transfer in the direction parallel with the charge trap layer 126 may be controlled by Poole-Frenkel tunneling. The current density by Poole-Frenkel tunneling may be represented by Poole-Frenkel conduction equation (Equation 1):

$$ J = q\mu N_C E \, exp(\frac{-q\,(E_T - \sqrt{qE/\pi\varepsilon})}{kT}) \quad \ldots \text{(equation 1)} $$

(J : current density, q : electronic charge, $\mu$ : carrier mobility $N_c$ : density of states in conduction band, E : electric field, $E_T$ : trap energy, $\varepsilon$ : permittivity, k : Boltzmann constant, T : temperature).

The charge transfer in the direction parallel with the charge trap layer 126 due to Poole-Frenkel tunneling may be determined by the trap energy ($E_T$) and the trap density ($N_T$) in the charge trap layer. The trap energy means a voltage barrier which electrons may cross to move from one atom to another atom in a material. That is, the trap energy may refer to a depth of a trap state with respect to a conduction band minimum (CBM) of a material. The trap density may refer to the number of charges trapped per unit volume. The trap density may be calculated by using a charge pumping method. The charge retention characteristics in the direction parallel with the charge trap layer 126 may be improved by high trap energy and high trap density.

The charge trap layer 126 may include, for example, at least one of silicon nitride (SiN), gallium nitride (GaN), gallium oxide (GaO), hafnium oxide (HfO), scandium oxide (ScO), strontium oxide (SrO), zirconium oxide (ZrO), yttrium oxide (YO), tantalum oxide (TaO), barium oxide (BaO), or zinc sulfide (ZnS).

The charge trap layer 126 may include a matrix and nano crystals in the matrix. The matrix may include amorphous metal oxynitride. The matrix may include metal oxynitride having a greater permittivity than silicon nitride. For example, the matrix may include at least one of AlON, ZrON, LaON, AlSiON, HfAlON, LaSiON, AlZrON, LaAlON, HfAlON, or ZrSiON. However, the disclosure is not limited thereto. For example, the nano crystals may include at least one of AlN, GaN, GeN, SiN, CN, InN, YN, ScN, or ZrN. However, the disclosure is not limited thereto.

As the charge trap layer 126 includes amorphous metal oxynitride in which nano crystals having semiconductor characteristics are dispersed, the trap energy and the trap density may increase, and the charge retention characteristics may be improved by suppressing the transfer of charges trapped between the memory cells MC. Accordingly, a threshold voltage may decrease, resulting in improvement in memory operation characteristics.

The charge blocking layer CB may block or prevent leakage of charges over the charge trap layer 126 to the boron nitride film 132 and the gate electrode 131. The charge blocking layer CB may include, for example, a first charge blocking layer 128 arranged on the charge trap layer 126 and a second charge blocking layer 129 arranged on the first charge blocking layer 128. The first charge blocking layer 128 may be in direct contact with the charge trap layer 126. However, the disclosure is not limited thereto, and another layer may be arranged between the charge trap layer 126 and the first charge blocking layer 128. The first charge blocking layer 128 may include, silicon oxide, metal oxide, or metal nitride. However, the disclosure is not limited thereto. The first charge blocking layer 128 may include at least one of aluminum oxide (AlO), magnesium oxide (MgO), aluminum nitride (AlN), or gallium nitride (GaN). The first charge blocking layer 128 may include, for example, $SiO_2$ or $Al_2O_3$.

The second charge blocking layer 129 may include a ferroelectric material or an anti-ferroelectric material. The ferroelectric material is a material having ferroelectricity which maintains spontaneous polarization by aligning electric dipole moments even when no electric field is applied thereto. The ferroelectric material may show spontaneous polarization by permanent dipole moments aligned in the same direction. The ferroelectric material may have remnant polarization by dipole even in a state where there is no external electric field. Moreover, a polarization direction may switch according to a domain unit by an external electric field. The threshold voltage of the vertical nonvolatile memory device 100 may change according to the switching of the polarization direction of the ferroelectric material, for example, from the gate electrode 131 towards the channel layer 122 or from the channel layer 122 towards the gate electrode 131.

The anti-ferroelectric material may include an array of electric dipoles, but the remnant polarization may be 0 or close to 0. In a state where there is no electric field, directions of adjacent dipoles are opposite to each other and then offset with each other, and the spontaneous polarization and remnant polarization may be 0 or close to 0. However, in a state where an external electric field is applied, the polarization characteristics and switching characteristics may appear.

The ferroelectric material may include a hafnium oxide material or an aluminum nitride material. The ferroelectric material may have a structure in which a dopant is injected into a hafnium oxide-based material or a structure in which a dopant is injected into an aluminum nitride-based material. When the ferroelectric material is a hafnium oxide-based material, the dopant may be Zr, La, Al, Si, or Y. When the ferroelectric material is an aluminum nitride-based material, the dopant may be B or Sc.

The ferroelectric material may include a ferroelectric material having, for example, at least one of a fluorite structure, a perovskite structure, or a wurtzite structure.

The ferroelectric material having a fluorite structure may include, for example, $HfO_2$ or $ZrO_2$. $HfO_2$ or $ZrO_2$ may have a crystal structure of tetragonal system or a crystal structure of orthorhombic system. The crystal structure of tetragonal system may have anti-ferroelectricity, and the crystal structure of orthorhombic system may have ferroelectricity. Undoped $HfO_2$ may have the stable crystal structure of tetragonal system or may have the crystal structure of orthorhombic system, depending on the size of crystal grain. Undoped $ZrO_2$ may have the stable crystal structure of tetragonal system. Undoped $HfO_2$ or $ZrO_2$ may include nano crystals having a grain size of about 1 nm to about 3 nm. However, the disclosure is not limited thereto.

The fluorite-based material may include, for example, $HfO_2$ or $ZrO_2$ including a dopant. The dopant may include, for example, at least one of Al, Ga, Co, Ni, Mg, In, La, Y, Nd, Sm, Er, Sr, Ba, Gd, Ge, N, or Si. However, this is only an example. $HfO_2$ or $ZrO_2$ including a dopant may have the crystal structure of tetragonal system having anti-ferroelectricity or the crystal structure of orthorhombic system according to the grain size and doping concentration. When the grain size is small and the doping concentration is high, the crystal structure of tetragonal system may be stable, and when the grain size is great and the doping concentration is low, the crystal structure of orthorhombic system may be stable.

$HfO_2$ or $ZrO_2$ doped with a dopant may include nanocrystals having a greater grain size than the undoped $HfO_2$ or $ZrO_2$. For example, $HfO_2$ or $ZrO_2$ doped with a dopant may have a grain size of about 4 nm to about 7 nm or about 4 nm to about 5 nm. However, the disclosure is not limited thereto.

The dopant concentration may vary according to a type of dopant. For example, when the dopant is Si, the doping concentration may be about 1 at% (atomic percent) to about 5 at%. However, the disclosure is not limited thereto.

The ferroelectric material having a perovskite structure may include a material having an ABOs composition wherein A and B each represent a metal element. The perovskite-based material may include, for example, at least one of PbZrOs, PbTiOs, BaTiOs, SrTiOs, or CaTiOs. However, the disclosure is not limited thereto. The perovskite-based material may have the crystal structure of tetragonal system having anti-ferroelectricity or the crystal structure of orthorhombic system having ferroelectricity according to a composition ratio of constituent elements.

The wurtzite-based material may include undoped AlN, GaN, or InN or may include AlN, GaN, or InN each including a dopant. The dopant may include at least one of boron (B) or scandium (Sc).

For example, the second charge blocking layer 129 may include hafnium zirconium oxide (HfZrO), and Zr/(Hf+Zr) may be about 20 at% to about 80 at%.

FIGS. 4A to 4C are cross-sectional views for illustrating a method of manufacturing the boron nitride film according to an example embodiment.

A substrate S may be prepared in a chamber (not shown). Although FIG. 4A simply illustrates only the substrate S, a middle structure of an integrated circuit in which a boron nitride film is to be formed may be present on the substrate S. The substrate S may include at least one of a group IV semiconductor material, a semiconductor compound, an insulating material, and metal. For example, the substrate S may include a group IV semiconductor material such as Si, Ge, Sn, etc. The substrate S may include, for example, at least one of Si, Ge, C, Zn, Cd, Al, Ga, In, B, C, N, P, S, Se, As, Sb, Te, Ta, Ru, Rh, Ir, Co, Ta, Ti, W, Pt, Au, Ni, or Fe. Further, the substrate S may further include N and F as a SiCOH-based composition and may include pores to decrease permittivity. The substrate S may further include a dopant. The aforementioned materials of the substrate S are just an example.

The substrate S may be pre-processed before the substrate S is arranged in the chamber. For example, after the substrate S is immersed in an organic solvent such as acetone, the substrate S may be cleansed by using nitrogen gas. By performing a plasma process using oxygen, hydrogen, $NH_3$, etc. on a surface of the cleansed substrate S, carbon impurities remaining on the surface may be removed. In addition, the substrate S may be immersed in an HF solution, and a native oxide may be removed. Then, the remaining HF solution may be removed by using anhydrous and $N_2$ gas.

After the cleansed substrate S is prepared in the chamber, the carbon impurities remaining on the surface of the substrate S may be removed by performing the plasma process on the surface of the substrate S in the chamber. For example, the surface of the substrate S may be $H_2$ plasma-processed at about 200 °C to about 800 °C. During the $H_2$ plasma-process performed on the surface of the substrate S, the flow rate of $H_2$ may be controlled to about 20 standard cubic centimeters (sccm) to about 200 sccm, and the plasma power may be maintained at about 20 W to about 100 W or about 30 W to about 100 W.

The process temperature for growth of the boron nitride film may be 700 °C or less, which is lower than the temperature used in the chemical vapor deposition process. For example, to grow the boron nitride film into an amorphous state, the process temperature in the chamber may be about 400 °C. Furthermore, before raising the process temperature, the process pressure for the growth of the boron nitride film may be set to be 2 Torr or less. For example, the process pressure may be $10^{-2}$ Torr or less. The process pressure for growing a nanocrystalline boron nitride film may be 10 mTorr or higher. For example, the process pressure for growing the nanocrystalline boron nitride film may be about 10 mTorr to about 1 Torr.

Then, a reaction gas may be injected into the chamber for the growth of the boron nitride film. The reaction gas may be a source for boron nitride for growing the boron nitride film and may be a source including both of nitrogen and boron such as borazine (B3N3H6) or ammonia-borane (NH3-BH3). The reaction gas may include a nitrogen source including nitrogen and a boron source including boron. The nitrogen source may include at least one of ammonia ($NH_3$) or nitrogen ($N_2$), and the boron source may include at least one of $BH_3$, $BF_3$, $BCl_3$, $B_2H_6$, $(CH_3)_3B$, or $(CH_3CH_2)_3B$.

The reaction gas may further include a carrier gas. The carrier gas may further include an inert gas. The inert gas may include, for example, at least one of an argon gas, a neon gas, a nitrogen gas, a helium gas, a krypton gas, or a xenon gas. The reaction gas may further include a hydrogen gas. A mixing ratio of the reaction gas injected into the chamber may vary according to the growth conditions of the boron nitride film.

The flow rate of the gas for boron nitride may be lower than other reaction gases. To grow the boron nitride film by using plasma, the volume ratio between the source for boron nitride and the inert gas may be, for example, about 1:10 to 1:5,000, or the volume ratio among the source boron nitride, the inert gas, and the hydrogen gas may be, for example, about 1:10 to 5,000:10 to 5,000.

To form the nanocrystalline boron nitride film, the amount of the source for boron nitride in the reaction gas needs to be relatively small, and to this end, the flow rate of the source for boron nitride flowing into the chamber may be relatively low. For example, the flow rate of the source for boron nitride may be about 0.03 sccm to about 1 sccm. For example, during the growth of the boron nitride film, the flow rate of the source for boron nitride may be controlled to be 0.05 sccm, and the flow rate of the inert gas may be controlled to be 50 sccm. The flow rate of the hydrogen gas may be controlled to be 20 sccm.

While the reaction gas flows into the chamber, the plasma power may be maintained at about 20 W to about 100 W or about 30 W to about 100 W, and the process temperature may be maintained at about 200 °C to about 800 °C. The plasma apparatus may be an apparatus providing plasma, including inductively coupled plasma, microwave plasma, capacitively coupled discharge plasma, electron cyclotron resonance plasma, helicon plasma, etc. However, the disclosure is not limited thereto. When an electric field is induced in the chamber of the plasma apparatus, by the induced electric field, plasma for growing the nanocrystalline boron nitride film may be generated.

As the ratio of the source for boron nitride is lower than other reaction gases, the crystallinity of boron nitride may be weakened. Thus, the boron nitride film 132 according to an example embodiment may be formed in an amorphous or nano-scale crystal structure.

For example, an inductively coupled plasma apparatus may provide a current generated by electromagnetic induction (e.g., a kind of plasma to which energy is supplied by a magnetic field varying according to time). When power for generation of plasma is applied to the inside of the chamber from the plasma apparatus, an electric field may be induced inside the chamber. When the reaction gas is injected, and an electric field is induced, plasma for growing the boron nitride film 132 may be formed.

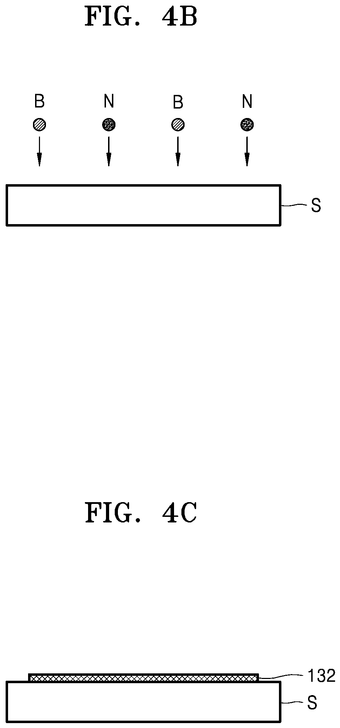

Referring to FIG. 4B, nitrogen (N*) and boron (B*) activated by plasma of the reaction gas obtained by mixing the carbon source, the inert gas, and the hydrogen gas may be generated and adsorbed on the surface of the substrate S. Then, as the plasma of the inert gas continuously induces the activation of the substrate S, the adsorption of the activated nitrogen (N*) and the activated boron (B*) on the surface of the substrate S may be accelerated. The activated nitrogen (N*) and the activated boron (B*) may be adsorbed in an amorphous manner. Even when the activated nitrogen and boron are bonded to each other, the amount thereof may be small, and thus, the nitrogen and boron may be adsorbed as a nano-scale crystal.

Referring to FIG. 4C, as the adsorption of the activated nitrogen (N*) and the activated boron (B*) on the surface of the substrate S is accelerated event at a low temperature, the boron nitride film 132 may be grown on the surface of the substrate S. According to the example embodiment, at a low temperature, e.g., at a temperature of 700 °C or less, a boron nitride film BN may be grown on the surface of the substrate S directly by the activated boron (B*) and the activated nitrogen (N*) of a low ratio, the boron nitride film 132 may have a weak crystallinity.

The boron nitride film 132 according to an example embodiment may be grown amorphously or may be grown in nano-scale crystals. Even when the amorphously formed boron nitride film 132 has a crystal, the size thereof may be 3 nm or less, and the boron nitride film 132 formed in nano crystals may include crystals having a size of 100 nm or less. The boron nitride film 132 may have an amorphous structure or may include a nanocrystal structure having a size of about 0.5 nm to about 100 nm.

The boron nitride film 132 may have the thickness d2 of 16 nm or less. As the boron nitride film 132 may include an amorphous material or nano crystals, the boron nitride film 132 may be thin.

After the growth, plasma may be turned off, and the furnace may be slowly cooled down. For example, by injecting $H_2$ gas of 20 sccm into the chamber, the furnace may be cooled to the room temperature.

A device may be manufactured by forming another layer at the boron nitride film 132 manufactured by the aforementioned method. The manufactured boron nitride film may be transferred to another layer. The hydrofluoric acid transfer technique may be applied. However, the disclosure is not limited thereto.

As the boron nitride film 132 manufactured as illustrated in FIGS. 4A to 4C is directly grown from the activated nitrogen and boron having a low density at a low temperature, the crystallinity may be low. When at least one of the process temperature and the process pressure is low, the amount of amorphous material may be high.

A ratio of nitrogen and a ratio of boron in the boron nitride film 132 may be substantially identical to each other. A ratio of boron to nitrogen may be about 0.9 to about 1.1. In addition, the boron nitride film 132 may include hydrogen. However, the amount of hydrogen in the boron nitride film 132 may be small. For example, the amount of hydrogen may be 10 at% or less. As the boron nitride film 132 includes a small amount of hydrogen, the boron nitride film 132 may be chemically stable.

The boron nitride film 132 may have a dielectric constant of 4 or less at an operating frequency of about 100 kHz (the dielectric constant may refer to a relative dielectric constant with respect to vacuum or air. For example, an amorphous boron nitride film (a-BN) may have a dielectric constant of 2.3 or less at an operating frequency of about 100 kHz, and a nanocrystal boron nitride film (nc-BN) may have a dielectric constant of about 2.3 to about 4 at an operating frequency of about 100 kHz.

The boron nitride film 132 may have a Young's modulus of 60 Gpa or greater. For example, the boron nitride film 132 may have a Young's modulus of about 60 Gpa to about 200 Gpa. For example, the boron nitride film 132 may have a Young's modulus of about 60 Gpa to about 150 Gpa. As the boron nitride film 132 has excellent mechanical properties such as Young's modulus, the physical/mechanical characteristics thereof may remain stable even in a thin thickness.

Moreover, the mass density of the boron nitride film 132 according to an example embodiment may change according to the dielectric constant of the boron nitride film 132. For example, the boron nitride film 132 may have a mass density of about 1 $g/cm^2$ to about 3 $g/cm^2$. The breakdown field of the boron nitride film 132 may be 4 $MVcm^{-1}$ or greater. For example, the breakdown field of the boron nitride film 132 may be about 5 $MVcm^{-1}$ to about 10 $MVcm^{-1}$.

The surface of the boron nitride film 132 may be smooth. For example, the surface roughness of the boron nitride film 132 may be about 0.3 root-mean-square (RMS) to about 0.6 RMS. The surface roughness of the boron nitride film 132 may be determined by the flow rate of the source for boron nitride.

To obtain the characteristics of the boron nitride film 132, a boron nitride film was grown on a Si substrate by using an inductively coupled plasma-chemical vapor deposition method at a process temperature of about 400 °C and process pressure of about $10^{-4}$ Torr. However, the manufacturing process is not limited thereto.

By varying the conditions of the process of forming the boron nitride film 132 (e.g., process temperature, plasma power, etc.), the properties of the boron nitride film 132 may change slightly. When both of the process temperature and the plasma power are low, the amorphous boron nitride film 132 may be formed. For example, when the process temperature is 200 °C, and the plasma power is 20 W, the amorphous boron nitride film 132 may be formed. When the process temperature is higher than 200 °C, and the plasma power is greater than 20 W, the nanocrystal boron nitride film 132 may be formed.

As such, even when the vertical nonvolatile memory device is miniaturized by employing the boron nitride film 132 having a low dielectric constant and a high Young's modulus as an insulating layer between the gate electrodes 131, the thickness of the insulating layer becomes thin, but the structure of the device may remain stable.

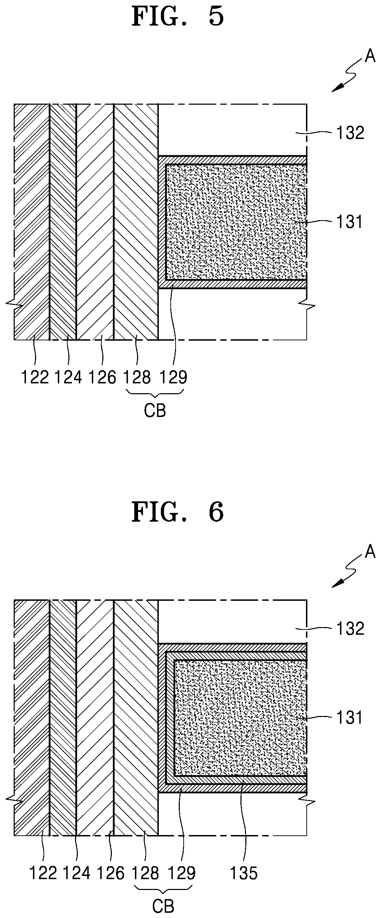

FIG. 5 illustrates an example of a change in a structure of the second charge blocking layer 129. The second charge blocking layer 129 may be arranged to surround some surfaces of the gate electrode 131. For example, the second charge blocking layer 129 may surround three surfaces of the gate electrode 131. As such, the second charge blocking layer 129 may be independently arranged per memory cell MC.

FIG. 6 illustrates an example in which a diffusion preventing layer 135 is further provided on the second charge blocking layer 129. The diffusion preventing layer 135 may mitigate or prevent reaction and diffusion between interfaces of the gate electrode 131 and the boron nitride film 132 or between the gate electrode 131 and the charge trap layer 126. The diffusion preventing layer 135 may include a material having a greater oxidation-reduction potential than the boron nitride film 132. The diffusion preventing layer 135 may include at least one of titanium (Ti), zirconium (Zr), vanadium (V), aluminum (Al), lanthanum (La), niobium (Nb), or tantalum (Ta) or include nitride including at least one of the foregoing elements (e.g., at least one of titanium (Ti), zirconium (Zr), vanadium (V), aluminum (Al), lanthanum (La), niobium (Nb), or tantalum (Ta)). The diffusion preventing layer 135 may include, for example, TiN or NbN.

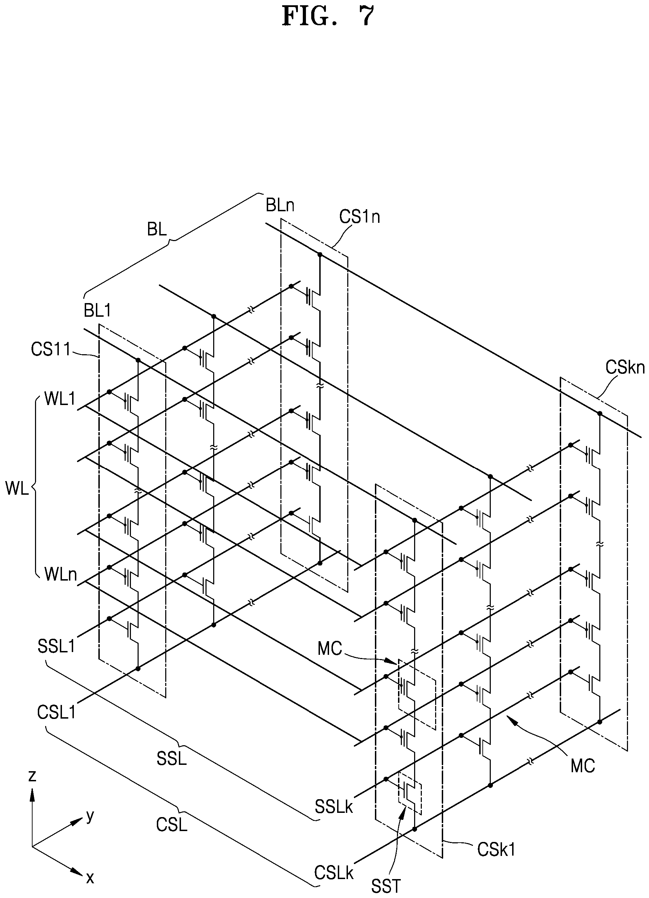

FIG. 7 is a circuit diagram including a vertical nonvolatile memory device according to an example embodiment. k*n cell strings CS may be arranged in a matrix and may be denoted by CSij according to a row and a column ($1 \leq i \leq k$, $1 \leq j \leq n$). Each cell string CSij may be connected to a bit line BL, a string select line SSL, a word line WL, and a common source line CSL.

Each cell string CSij may include memory cells MC and a string select transistor SST. The memory cells MC and the string select transistor SST of each cell string CSij may be stacked in the height direction.

Rows of the plurality of cell strings CS may respectively be connected to different string select lines (SSL1 to SSLk) from each other. For example, the string select transistors SST of the cell strings CS11 to CS1n may be commonly connected to the string select line SSL1. The string select transistors SST of the cell strings CSk1 to CSkn may be commonly connected to the string select line SSLk.

Columns of the plurality of cell strings CS may respectively be connected to different bit lines (BL1 to BLn) from each other. For examples, the memory cells MC and the string select transistors SST of the cell strings CS11 to CSk1 may be commonly connected to the bit line BL1, and the memory cells MC and the string select transistors SST of the cell strings CS1n to CSkn may be commonly connected to the bit line BLn.

The rows of the plurality of cell strings CS may be respectively connected to different common source lines (CSL1 to CSLk) to each other. For example, the string select transistors SST of the cell strings CS11 to CS1n may be commonly connected to the common source line CSL1, and the string select transistors SST of the cell strings CSk1 to CSkn may be commonly connected to the common source line CSLk.

The memory cells MC located at the same height from the string select transistors SST or the substrate may be commonly connected to one word line WL, and the memory cells MC located at different heights from each other may respectively be connected to different word lines (WL1 to WLn) from each other.

The circuit structures illustrated in the drawings are just an example. For example, the number of rows of the cell strings CS may increase or decrease. When the number of rows of the cell strings CS changes, the number of string select lines connected to the rows of the cell strings CS and the number of cell strings CS connected to one bit line BL may also change. When the number of rows of the cell strings CS changes, the number of common source lines connected to the rows of the cell strings CS may also change.

The number of columns of the cell strings CS may also increase or decrease. When the number of columns of the cell strings CS changes, the number of bit lines BL connected to the columns of the cell strings CS and the number of cell strings CS connected to one string select line may also change.

The height of the cell strings CS may also increase or decrease. For example, the number of memory cells MC stacked in each cell string CS may increase or decrease. When the number of memory cells MC stacked in each cell string CS changes, the number of word lines WL may also change. For example, the number of string select transistors provided to each cell string CS may increase. When the number of string select transistors provided to each cell string CS changes, the number of string select lines or common source lines may also change. When the number of string select transistors SST increases, the string select transistors SST may be stacked in the same manner as the memory cells MC.

For example, the reading and writing may be performed by the unit of row of the cell strings CS. The cell strings CS may be selected as a row unit by the common source line CSL, and the cell strings CS may be selected as a row unit by the string select line SSL. In addition, a voltage may be applied to at least two common source lines CSL as a unit. In some example embodiments, a voltage may be applied to the all of common source lines CSL as a unit.

The reading and writing may be performed by a page at a selected row of the cell strings CS. The page may be a row of the memory cells connected to one word line WL. At a selected row of the cell strings CS, the memory cells may be selected by the word lines WL by the unit of page. For example, the gate electrode 131 of FIG. 1 may be connected to one of the word line WL and the string select line SSL.

The memory cell MC may have a circuit structure in which a transistor including the gate electrode 131, the boron nitride film 132, and the channel layer 122 is connected to the charge trap layer 126.

Such memory cell MC is arranged continuously in the vertical direction (Z direction) to constitute the cell string CS. In addition, both ends of the cell string CS may be connected to the common source line CSL and the bit line BL as illustrated in the circuit diagram of FIG. 7. By applying a voltage to the common source line CSL and the bit line BL, a program, a reading process, a deleting process may be performed on the plurality of memory cells MC.

For example, when a memory cell MC for writing is selected, a gate voltage value of the memory cell may be adjusted such that no channel is formed in the selected memory cell (channel-off), and a gate voltage value of unselected memory cells may also be adjusted to channel-on the unselected memory cells. Accordingly, charges may tunnel through the charge tunneling layer 124 by the voltage applied to the common source line CSL and the bit line BL and may be stored in the charge trap layer 126 of the selected memory cell MC. Then, desired information of 1 or 0 may be written onto the selected memory cell MC.

Similar to the above, in the reading operation, the reading may be performed on a selected cell. That is, the gate voltages applied to the gate electrodes 131 may be adjusted to channel on the selected memory cell MC and channel off the unselected memory cells MC, and then, a current flowing in the memory cell MC by an applied voltage Vread between the common source line CSL and the bit line BL may be measured to identify a memory cell state (1 or 0).

The vertical nonvolatile memory device 100 may have a structure in which cells are connected to each other in the vertical direction. When information is stored, charges may diffuse in the vertical direction and move to adjacent cells to affect operations of the adjacent cells.

In the vertical nonvolatile memory device according to an example embodiment, as the boron nitride film may be applied as an insulating layer between the gate electrodes 131, and the boron nitride film has a low permittivity and a high Young's modulus, the vertical nonvolatile memory device may be used in integrated circuits of various electronic apparatuses to reduce the parasitic capacitance. In addition, as the boron nitride film has excellent mechanical properties including a hardness and a Young's modulus, the physical/mechanical characteristics thereof may remain stable even in a thin thickness.

As the vertical nonvolatile memory device according to an example embodiment has advantages described above, it may be applied to various electronic apparatuses.

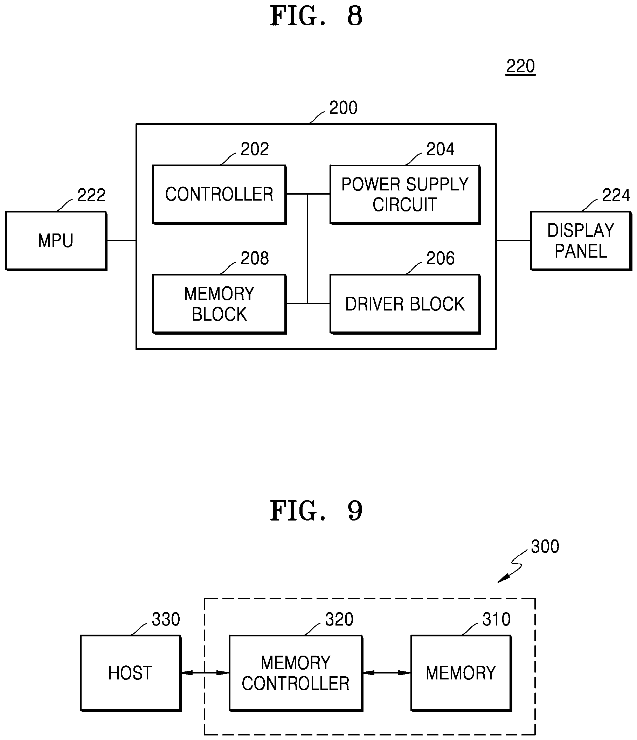

FIG. 8 is a schematic block diagram of a display driver integrated circuit (DDI) 200 and a display apparatus 220 including the DDI 200 according to an example embodiment. Referring to FIG. 8, the DDI 200 may include a controller 202, a power supply circuit 204, a driver block 206, and a memory block 208. The controller 202 may receive and decode a command applied from a main processing unit (MPU) 222 and control each block of the DDI 200 to implement an operation according to the command. The power supply circuit 204 may generate a driving voltage in response to the control by the controller 202. In response to the control by the controller 202, the driver block 206 may drive a display panel 224 by using the driving voltage generated from the power supply circuit 204. The display panel 224 may be, for example, a liquid crystal display panel, an organic light-emitting device (OLED) display panel, or a plasma display panel. The memory block 208, as a block temporarily storing commands input to the controller 202 or control signals output from the controller 202 or storing required data, may include memory such as RAM, ROM, etc. For example, the memory block 208 may include the vertical nonvolatile memory device 100 according to the example embodiments described above.

FIG. 9 is a block diagram of an electronic apparatus 300 according to an example embodiment. Referring to FIG. 9, the electronic apparatus 300 may include a memory 310 and a memory controller 320. In response to a request from a host 330, the memory controller 320 may control the memory 310 to read data from the memory 310 and/or write data onto the memory 310. The memory 310 may include the vertical nonvolatile memory device 100 according to the example embodiments described above.

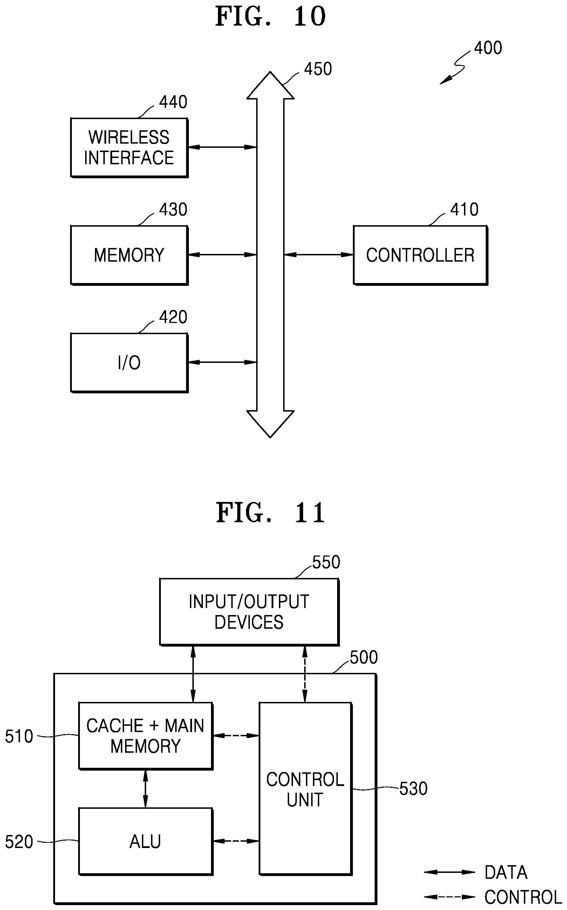

FIG. 10 is a block diagram of an electronic apparatus 400 according to an example embodiment. Referring to FIG. 10, the electronic apparatus 400 may constitute a wireless communication apparatus or an apparatus capable of transmitting and/or receiving information in a wireless environment. The electronic apparatus 400 may include a controller 410, an input/output (I/O) apparatus 420, a memory 430, and a wireless interface 440, which are interconnected to each other through a bus 450.

The controller 410 may include a microprocessor, a digital signal processor, or at least one of process apparatuses of a similar kind. The I/O apparatus 420 may include at least one of a keypad, a keyboard, or a display. The memory 430 may be used to store a command executed by the controller 410. For example, the memory 430 may be used to store user data. The electronic apparatus 400 may use the wireless interface 440 to transmit/receive data through a wireless communication network. The wireless interface 440 may include an antenna and/or a wireless transceiver. In some example embodiments, the electronic apparatus 400 may be used to a communication interface protocol of a 3rd generation communication system, for example, code division multiple access (CDMA), global system for mobile communications (GSM), north American digital cellular (NADC), extended-time division multiple access (E-TDMA), and/or wide band code division multiple access (WCDMA). The memory 430 of the electronic apparatus 400 may include the vertical nonvolatile memory device 100 according to the example embodiments described above.

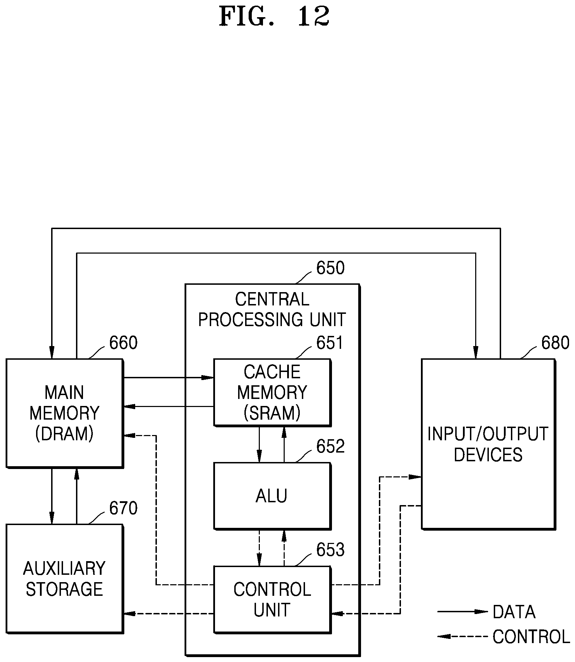

FIGS. 11 and 12 are each a conceptual diagram schematically illustrating a device architecture applicable to electronic apparatuses according to some example embodiments.

Referring to FIG. 11, an electronic device architecture 500 may include a memory unit 510 and a control unit 530 and may further include an arithmetic logic unit (ALU) 520. The memory unit 510, the ALU 520, and the control unit 530 may be electrically connected to each other. For example, the electronic device architecture 500 may be implemented as a single chip including the memory unit 510, the ALU 520, and the control unit 530. For example, the memory unit 510, the ALU 520, and the control unit 530 may be interconnected by a metal line on an on-chip and communicate directly with each other. The memory unit 510, the ALU 520, and the control unit 530 may be integrated on one substrate (101 of FIG. 1) in a monolithic manner and constitute a single chip. An input/output device 550 may be connected to the electronic device architecture (chip) 500. The memory unit 510 may include both of a main memory and a cache memory. Such electronic device architecture (chip) 500 may be an on-chip memory processing unit. The memory unit 510, the ALU 520, and/or the control unit 530 may each independently include the vertical nonvolatile memory device 100 according to the example embodiments described above.

Referring to FIG. 12, a cache memory 651, an ALU 652, and a control unit 653 may constitute a central processing unit (CPU) 650, and the cache memory 651 may include static random access memory (SRAM). Separately from the CPU 650, a main memory 660 and an auxiliary storage 670 may be provided, and an input/output device 680 may be further provided. The main memory 660 may be, for example dynamic random access memory (DRAM) and may include the vertical nonvolatile memory device 100 according to the example embodiments described above.

In some cases, the electronic device architecture may be implemented in a form in which computing unit devices and memory unit devices are adjacent to each other on a single chip without separating into sub-units.

The vertical nonvolatile memory device according to the above example embodiments may be applied to various user apparatus such as a computer, a laptop computer, an ultra mobile personal computer (UMPC), a workstation, a net-book, a personal digital assistant (PDA), a portable computer, a web tablet, a wireless phone, a mobile phone, a smart phone, a digital camera, a digital audio recorder, a digital audio player, a digital picture recorder, a digital picture player, a digital video recorder, a digital video player, an apparatus capable of receiving and transmitting information in a wireless environment, and a home network.

The vertical nonvolatile memory device according to the above example embodiments may include the boron nitride film having a relatively low dielectric constant and a relatively high Young's modulus. By applying the boron nitride film having a small thickness as an insulating layer between the gate electrodes 131, the parasitic capacitance between the gate electrodes may be reduced. In addition, as the boron nitride film of the vertical nonvolatile memory device according to the above example embodiment has excellent mechanical properties such as a Young's modulus, even when the thickness thereof is thin. Thus, the boron nitride film may have stable physical/mechanical characteristics. Accordingly, a vertical nonvolatile memory device may be implemented, while reducing or minimizing performance degradation due to the cross-talk between the gate electrodes.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that the example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

**Claims**

1. A vertical nonvolatile memory device comprising a plurality of cell strings, wherein each of the plurality of cell strings comprises:

   a channel layer;
   a charge tunneling layer on the channel layer;
   a charge trap layer on the charge tunneling layer;
   a charge blocking layer on the charge trap layer;
   a gate electrode on the charge blocking layer; and
   a boron nitride film on the gate electrode, and
   wherein the gate electrode and the boron nitride film are alternately stacked, and
   the boron nitride film has a dielectric constant of 4 or less at an operating frequency of 100 kHz and has a Young's modulus of 60 Gpa or greater.

2. The vertical nonvolatile memory device of claim 1, wherein the boron nitride film has a thickness of 16 nm or less.

3. The vertical nonvolatile memory device of claim 1 or 2, wherein a ratio of boron to nitrogen of the boron nitride film is 0.9 to 1.1.

4. The vertical nonvolatile memory device of any preceding claim, wherein the boron nitride film has a mass density of 1 $g/cm^3$ to 3 $g/cm^3$

5. The vertical nonvolatile memory device of any preceding claim, wherein the boron nitride film has a breakdown field of 4 $MVcm^{-1}$ or greater.

6. The vertical nonvolatile memory device of any preceding claim, wherein the boron nitride film has a roughness of 0.3 root-mean-square (RMS) to 0.6 RMS.

7. The vertical nonvolatile memory device of any preceding claim, wherein the boron nitride film has a hydrogen content of 10 % or less.

8. The vertical nonvolatile memory device of any preceding claim, wherein the boron nitride film has an amorphous structure or a nanocrystal structure.

9. The vertical nonvolatile memory device of any preceding claim, wherein the charge blocking layer includes a first charge blocking layer and a second charge blocking layer, and the second charge blocking layer includes a fluorite-based material, a perovskite-based material, or a wurtzite-based material, and optionally wherein the fluorite-based material includes $HfO_2$ or $ZrO_2$, and further optionally wherein the fluorite-based material further includes a dopant, and the dopant includes at least one of Al, Ga, Co, Ni, Mg, In, La, Y, Nd, Sm, Er, Sr, Ba, Gd, Ge, N, or Si.

10. The vertical nonvolatile memory device of claim 9, wherein the perovskite-based material includes a material having an ABOs composition where A and B are metal elements, and optionally wherein the perovskite-based material includes at least one of PbZrOs, PbTiOs, BaTiOs, SrTiOs, or CaTiOs.

11. The vertical nonvolatile memory device of claim 9 or 10, wherein the wurtzite-based material includes at least one of AlN, GaN, InN, doped AlN, doped GaN, or doped InN.

12. The vertical nonvolatile memory device of any of claims 9 to 11, wherein the second charge blocking layer has a thickness of 1 nm to 3 nm.

13. The vertical nonvolatile memory device of any preceding claim, further comprising:
a diffusion preventing layer between the gate electrode and the charge blocking layer.

14. The vertical nonvolatile memory device of claim 13, wherein the diffusion preventing layer includes,

at least one of titanium (Ti), zirconium (Zr), vanadium (V), aluminum (Al), lanthanum (La), niobium (Nb), or tantalum (Ta), or
includes nitride including at least one of titanium (Ti), zirconium (Zr), vanadium (V), aluminum (Al), lanthanum (La), niobium (Nb), or tantalum (Ta).

15. An electronic apparatus comprising:

a memory; and
a memory controller configured to control the memory to read data from the memory and/or write data on the memory,
wherein the memory comprises a vertical nonvolatile memory device according to any preceding claim.

# FIG. 1

# FIG. 2

# FIG. 3

122 124 126 128 129

CB

# FIG. 4A

Gas ($B_3N_3H_6$, Ar, $H_2$) Plasma

S

# FIG. 4B

B   N   B   N

S

# FIG. 4C

132

S

# FIG. 5

A

132

131

122 124 126 128 129

CB

# FIG. 6

A

132

131

122 124 126 128 129 135

CB

# FIG. 7

# FIG. 8

<u>220</u>

MPU — 222

200

CONTROLLER — 202

POWER SUPPLY CIRCUIT — 204

MEMORY BLOCK — 208

DRIVER BLOCK — 206

DISPLAY PANEL — 224

# FIG. 9

300

HOST — 330

MEMORY CONTROLLER — 320

MEMORY — 310

# FIG. 10

400

450

440
WIRELESS
INTERFACE

430
MEMORY

420
I/O

410
CONTROLLER

# FIG. 11

550
INPUT/OUTPUT
DEVICES

500

510
CACHE + MAIN
MEMORY

520
ALU

530
CONTROL
UNIT

→ DATA
---→ CONTROL

# FIG. 12

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2022/328515 A1 (KIM JEEYONG [KR] ET AL) 13 October 2022 (2022-10-13) * paragraphs [0022] - [0106]; figures 1, 14 * | 1-15 | INV.<br>H10D30/69<br>H10D64/01 |
| Y | US 2023/349072 A1 (CHOI TAEJIN [KR] ET AL) 2 November 2023 (2023-11-02) * paragraphs [0004] - [0074] * | 1-15 | |
| Y | US 2021/125930 A1 (SHIN HYEONJIN [KR] ET AL) 29 April 2021 (2021-04-29) * paragraphs [0081], [0095] - [0097] * | 4-6 | |
| Y | US 2023/157022 A1 (SHIN KEUNWOOK [KR] ET AL) 18 May 2023 (2023-05-18) * paragraph [0087] * | 13 | |
| Y | US 2019/319038 A1 (ZHANG GANG [KR]) 17 October 2019 (2019-10-17) * paragraph [0054] * | 14 | |
| | | | **TECHNICAL FIELDS SEARCHED (IPC)**<br><br>H10D<br>H10B |

The present search report has been drawn up for all claims

| Place of search | Date of completion of the search | Examiner |
|---|---|---|
| Munich | 23 May 2025 | Alessio Verni, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 598 301 A1**

## ANNEX TO THE EUROPEAN SEARCH REPORT
## ON EUROPEAN PATENT APPLICATION NO.

EP 25 15 0408

This annex lists the patent family members relating to the patent documents cited in the above-mentioned European search report.
The members are as contained in the European Patent Office EDP file on
The European Patent Office is in no way liable for these particulars which are merely given for the purpose of information.

23-05-2025

| Patent document cited in search report | Publication date | Patent family member(s) | Publication date |
|---|---|---|---|
| US 2022328515 A1 | 13-10-2022 | KR 20220140303 A | 18-10-2022 |
| | | US 2022328515 A1 | 13-10-2022 |
| US 2023349072 A1 | 02-11-2023 | CN 116960106 A | 27-10-2023 |
| | | EP 4270447 A1 | 01-11-2023 |
| | | KR 20230152454 A | 03-11-2023 |
| | | US 2023349072 A1 | 02-11-2023 |
| US 2021125930 A1 | 29-04-2021 | CN 112750834 A | 04-05-2021 |
| | | EP 3817051 A1 | 05-05-2021 |
| | | US 2021125930 A1 | 29-04-2021 |
| | | US 2022415800 A1 | 29-12-2022 |
| US 2023157022 A1 | 18-05-2023 | CN 116137782 A | 19-05-2023 |
| | | EP 4181647 A1 | 17-05-2023 |
| | | KR 20230071632 A | 23-05-2023 |
| | | US 2023157022 A1 | 18-05-2023 |
| US 2019319038 A1 | 17-10-2019 | CN 110364535 A | 22-10-2019 |
| | | KR 20190118751 A | 21-10-2019 |
| | | US 2019319038 A1 | 17-10-2019 |

EPO FORM P0459

For more details about this annex : see Official Journal of the European Patent Office, No. 12/82